(19) Europäisches Patentamt
European Patent Office
Office européen des brevets

(11) Veröffentlichungsnummer: **0 167 051**
**B1**

(12) # EUROPÄISCHE PATENTSCHRIFT

(45) Veröffentlichungstag der Patentschrift: **12.10.88**

(51) Int. Cl.⁴: **C 08 G 59/08**, C 08 G 59/16, G 03 F 7/10

(21) Anmeldenummer: **85107481.5**

(22) Anmeldetag: **18.06.85**

(54) **Thermostabiles, durch Bestrahlung vernetzbares Polymersystem auf der Basis von Bisphenolen und Epichlorhydrin sowie Verfahren zu seiner Verwendung.**

(30) Priorität: **29.06.84 DE 3424119**

(43) Veröffentlichungstag der Anmeldung: **08.01.86 Patentblatt 86/2**

(45) Bekanntmachung des Hinweises auf die Patenterteilung: **12.10.88 Patentblatt 88/41**

(84) Benannte Vertragsstaaten: **AT BE CH DE FR GB IT LI NL**

(56) Entgegenhaltungen:
**DE-A-3 230 560**
**US-A-3 387 976**

(73) Patentinhaber: **Siemens Aktiengesellschaft Berlin und München, Wittelsbacherplatz 2, D-8000 München 2 (DE)**

(72) Erfinder: **Budde, Klaus, Dr., Ulrich- von- Hutten-Strasse 35, D-8000 München 83 (DE)**
Erfinder: **Nuyken, Oskar, Dr., Titurelstrasse 7, D-8000 München 81 (DE)**

EP 0 167 051 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Thermostabiles, durch Bestrahlung vernetzbares Polymersystem auf der Basis von Bisphenolen und Epichlorhydrin sowie Verfahren zu seiner Verwendung.

Die Erfindung betrifft ein durch Bestrahlung zu einem thermostabilen Material vernetzbares Polymersystem, insbesondere geeignet zur Herstellung von Mehrlagenverdrahtungen, auf der Basis eines durch Reaktion von Bisphenolen und Epichlorhydrin erhältlichen Polykondensats als Grundgerüst, sowie ein Verfahren zur Herstellung von gedruckten Mehrlagenverdrahtungen unter Verwendung dieses Polymersystems.

Es ist bekannt, gedruckte Mehrlagenverdrahtungen durch Aufeinanderverpressen von das entsprechende Leitungsbild enthaltenden Dünnschichtlaminaten mittels Klebfolien herzustellen. Die Dünnschichtlaminate und Klebfolien bilden Isolierstoffschichten zwischen den einzelnen Leiterbahnebenen. Nach Entstehung der Mehrlagen-Leiterplatten werden durch Bohrungen und anschließende Durchkontaktierungen dieser Bohrungen die Leitungsverbindungen und Kontaktstellen zwischen den einzelnen Schichten hergestellt.

Um Rißbildungen in der Kontaktschicht, in den Zwischenschichten sowie Delaminierungseffekte beim Löten oder bei Wechseltemperaturbeanspruchungen zu vermeiden, wurde das eben beschriebene Verfahren dahingehend verbessert, daß die Dünnschichtlaminate beidseitig kupferkaschiert und mit einem Fotoresistlack beschichtet werden. Dieser Lack, welcher ein Negativ- oder ein Positiv-Lack sein kann, wird mit einer entsprechenden Maske abgedeckt, belichtet und entwickelt. Die verbleibenden entwickelten Harzschichten dienen als Resist beim anschließenden Ätzvorgang für das Kupfer. Nach dem Entfernen des Kupfers durch Ätzen entsteht das gewünschte Leiterbild, auf dem bei Verwendung eines Negativlackes der Fotoätzresistlack haftet. Diese Lackreste werden mit organischen Lösungsmitteln oder mechanisch entfernt und dann die nächste Lage aufgebracht.

Um die durch das Entfernen der Lackreste entstandenen Schäden an der Oberfläche des für den Aufbau der Laminate notwendigen Kunstharzes zu vermeiden, wird in der DE-OS 2 342 407 vorgeschlagen, als lichtempfindliches Material ein organisches Material zu verwenden, welches eine Verbindung mit Epoxidgruppen und mit elektromagnetischen Strahlen härtbaren Gruppen enthält. Pro Molekül soll das Harz etwa zwei Epoxidgruppen enthalten. Die durch die Belichtung vorgehärteten Teile der lichtempfindlichen Schicht werden unter Verwendung eines in der Wärme wirkenden Härters für Epoxidharze einer thermischen Nachbehandlung unterzogen und auf den Trägerfolien belassen. Die Verpressung der einzelnen beschichteten und behandelten Trägerfolien wird unter Zwischenschaltung von Klebfolien, welche aus einem mit einem Epoxidharz und einem Härter für Epoxidharze imprägnierten Glasgewebe bestehen, durchgeführt. Dabei ist es von Bedeutung, daß die nach der Belichtung vorliegende Vernetzung des Harzes noch erlaubt, daß der entstandene Lack noch nicht vollständig unlöslich und unschmelzbar geworden ist, damit die sich im Lack befindlichen Epoxidgruppen beim später erfolgenden Verpressen mit einer weiteren Lage Klebefolie bzw. Prepreg (= das sind mit Harz vorimprägnierte Glasfasergewebe oder Folien aus vernetztem Harz ohne Glasfaserverstärkung) eine Vernetzung mit dem zum Aufbau dieses Materials benutzten Epoxidharz eingehen, das heißt, es müssen noch eine genügende Anzahl von reaktionsfähigen Gruppen zur Vernetzung der Epoxidgruppen des Resistlackes vorhanden sein.

In einem US-Patent von Sorkin (US-A-3 387 976) ist ein Photopolymer auf der Basis eines durch Reaktion von Bisphenol A und Epichlorhydrin erhältlichen Polykondensats als Grundgerüst beschrieben, wobei die freien OH-Gruppen des Polykondensats mit Zimtsäure verestert sind. Dieses Photopolymer kann als Photoresist für Ätzprozesse eingesetzt werden, doch weist es ungenügende mechanische und thermische Beständigkeit auf. Auch die Lichtempfindlich keit und die elektrisch isolierenden Eigenschaften sind zu verbessern, damit ein solches Photopolymer zur Herstellung insbesondere von Mehrlagenverdrahtungen geeignet wäre.

Der Erfindung liegt daher die Aufgabe zugrunde, ein Polymersystem der eingangs genannten Art anzugeben, welches

a) die Herstellung von gedruckten Mehrlagenverdrahtungen gegenüber bisher bekannten Verfahren wesentlich vereinfacht,
b) die Herstellung maßgetreuer Strukturen erlaubt und deshalb auch für den Einsatz bei der Herstellung integrierter Halbleiterschaltungen in VLSI-Technik infrage kommt, und
c) vor allen Dingen die Möglichkeit schafft, die Belichtungszeit bei der Strukturerzeugung zu verkürzen.

Diese Aufgabe wird durch ein Polymersystem auf der Basis eines durch Reaktion von Bisphenolen mit Epichlorhydrin erhältlichen Polykondensats als Grundgerüst erfindungsgemäß dadurch gelöst, daß das Polymersystem durch Reaktion des Polykondensats mit lichtempfindlichen Säurechloriden erhalten wird und wobei das Polykondensat Bisphenolbausteine mit zwei und mehr reaktiven Hydroxylgruppen pro aromatischem Ring besitzt.

Es liegt im Rahmen der Erfindung, daß am Polykondensat pro regelmäßig wiederkehrender Struktureinheit vorzugsweise fünf zur Reaktion mit dem lichtempfindlichen Säurechlorid fähige Hydroxylgruppen vorhanden sind, wobei eine Hydroxylgruppe an den Epichlorhydrinrest und vier Hydroxylgruppen an den Bisphenolrest gebunden sind.

Ausgehend von der chemischen Struktur von Epoxidharzen auf der Basis von Bisphenol A

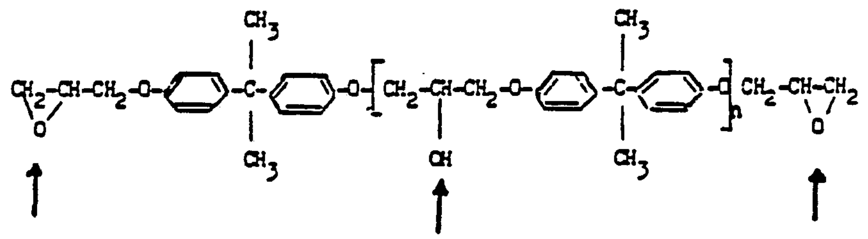

(1)

wobei n = 0, 1, 2, 3, .... und die senkrechten Pfeile die reaktiven Gruppen anzeigen, ergibt sich folgende chemische Struktur für ein Polykondensat:

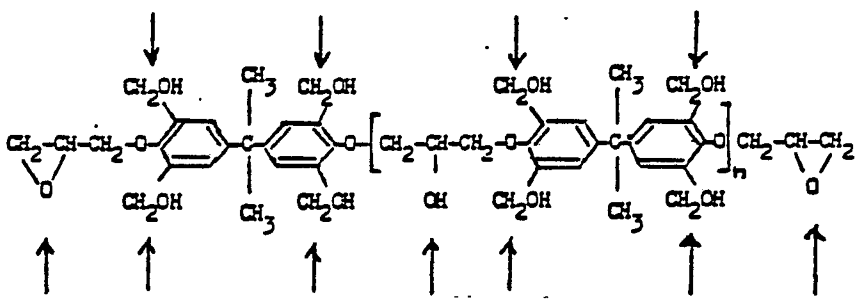

(2)

wobei gemäß diesem Ausführungsbeispiel die reaktiven Gruppen am Bisphenol A-Baustein aus Hydroxymethylengruppen bestehen. Zusätzlich zu den an der Epoxidrandgruppe (bekannt aus der DE-OS-2 342 407) befindlichen reaktiven Gruppen kommt je Molekülbaustein eine Hydroxylgruppe am Epichlorhydrin hinzu; vier Hydroxylgruppen sind erfindungsgemäß am Bisphenol-A-Baustein gebunden.

Bei der Umsetzung dieser Harzverbindung (2) mit zum Beispiel Zimtsäurechlorid

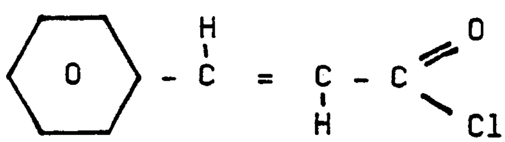

reagieren diese Gruppen zu folgender Struktur:

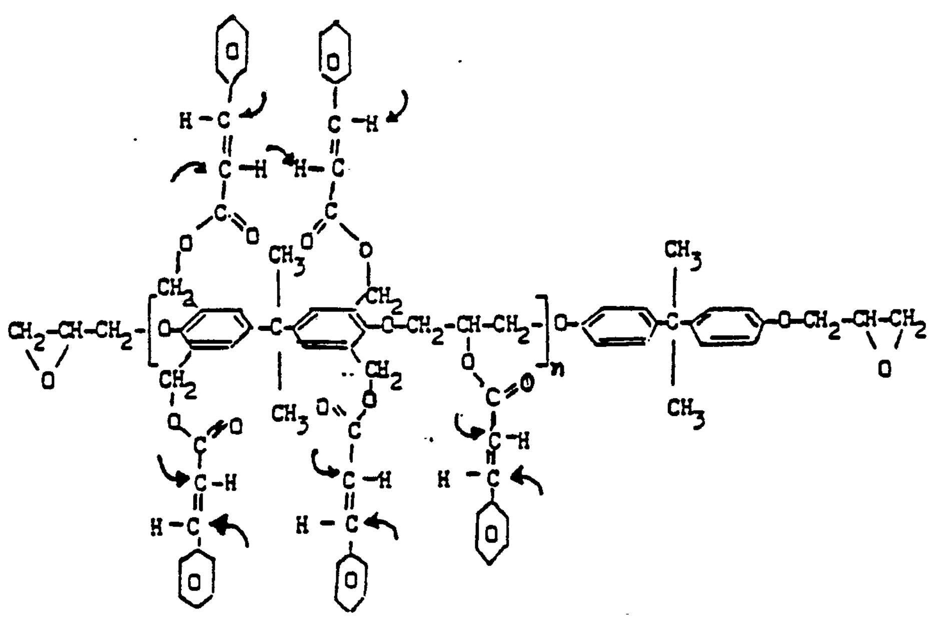

(3)

Die gebogenen Pfeile zeigen die reaktiven Gruppen für die Vernetzung durch Bestrahlung an (in der Struktur (3) ist der Einfachheit halber die Umsetzung mit Zimtsäurechlorid nur an einem Baustein gezeigt). Anstelle von Zimtsäurechlorid läßt sich auch Furfurylacrylsäurechlorid für die Umsetzung verwenden. Es entstehen dann

fotoreaktive Furfurylacrylsäurederivate.

In einer Weiterbildung des Erfindungsgedankens ist vorgesehen, daß das Polymersystem auch als Cokondensat vorliegen kann, wobei sowohl Polymerbausteine mit mindestens zwei reaktiven Hydroxylgruppen als auch Polymerbausteine mit weniger als zwei Hydroxylgruppen für die Umsetzung vorhanden sind.

Durch die erfindungsgemäße Substanzklasse werden folgende Vorteile gegenüber bekannten Polymersystemen erzielt:

1. Da zur Vernetzung mehr Doppelbindungen zur Verfügung stehen und die Doppelbindungen voneinander geringer entfernt sind als bei den bekannten Verbindungen, erfolgt die Vernetzung (Belichtungszeit) wesentlich schneller. Das bedeutet für das oben angeführte Ausführungsbeispiel die Reduzierung der Belichtungszeit auf ein Fünftel des bisherigen Wertes.

2. Durch die hohe sterische Hinderung steigt die Glastemperatur gegenüber den bisherigen Harzen deutlich an; dadurch werden Vorteile in der Verarbeitbarkeit des Harzes erzielt. Eine Änderung der Dielektrizitätskonstanten des Materials tritt nicht auf (wichtig für den Einsatz in der Leiterplattenfertigung). Wesentlich für eine Anfertigung kleiner Strukturen ist eine niedrige Dielektrizitätskonstante (Dk). Eine Dk von ca. 3 erlaubt beispielsweise Leiterbahnabstände von etwa 20 µm.

Die Herstellung des Epoxidharzes aus hydroxymethylierten Bisphenolen und Epichlorhydrin ist aus der DE-OS-3 230 560 Al zu entnehmen. Dort wird diese Substanzklasse in Verbindung mit Zement, Mörtel, Kies, Sand, Metallen, Holz, Papier und anderen Baumaterialien zur Verbesserung der Materialeigenschaften und zur Erzeugung von glänzenden Überzügen verwendet. Durch Strahlung und durch thermische Einwirkung lassen sich diese Polymere härten. Doch wird die Härtungsreaktion durch Säurezusatz katalysiert und führt zu chemisch anders gearteten Produkten, als der Erfindungsgegenstand.

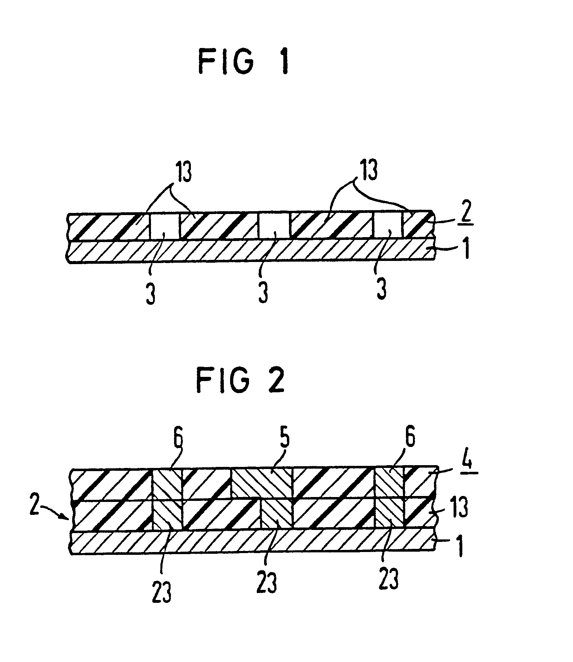

Im folgenden soll anhand eines Ausführungsbeispiels die Anwendung des erfindungsgemäßen Polymersystems zur Herstellung einer Mehrlagenverdrahtung beschrieben werden. Dabei ergibt sich, bedingt durch die Eigenschaft des Materials, ein neuer Aufbau für den mit elektrischen Leitungsbahnen und elektrischen Durchkontaktierungen versehenen Isolierstoffträger. Die Figuren 1 und 2 zeigen dabei im Schnittbild die erfindungsgemäßen Verfahrensschritte.

**Figur 1:** Als Träger wird eine Kupferfolie 1 verwendet, auf die eine Schicht 2 des fotovernetzbaren Isolierstoffes gemäß der Lehre der Erfindung (nach Zusatz von zum Beispiel Michlers Keton als Sensibilisator) durch Tauchen oder Sprühbelacken, beispielsweise in einer Schichtdicke von 5 - 20 µm aufgebracht wird. Die Schicht 2 wird in der Weise belichtet und entwickelt, daß die in ihr einzufügenden Durchkontaktierungen, das heißt die Anschlußpunkte der Chips als Durchbrechungen 3 in der Isolierstoffschicht 2 entstehen. Die Bestrahlung der Schicht erfolgt dabei unter Verwendung einer Maske (nicht abgebildet), die den Bereich der Durchbrechungen 3 der Schicht 2 abdeckt (Negativlack). Die abgedeckten Teile (3) werden anschließend mit einem entsprechenden Lösungsmittel herausgelöst, während bei den belichteten Teilen 13 der Schicht 2 eine chemische Vernetzung eingetreten ist, die eine Lösung verhindert, so daß diese Teile 13 als Isolierstoffschicht verbleiben. Nach der Herstellung der Durchbrechungen 3 für die dieser ersten Isolierstoffschicht 2 (13) zugeordneten Durchkontaktierungen werden die Durchbrechungen 3 im Zusammenhang mit der als Träger dienenden Kupferfolie 1 mittels galvanischer Metallisierung mit einem elektrisch gut leitenden Material, beispielsweise Kupfer, ausgefüllt (23 in Figur 2).

**Figur 2:** Anschließend wird auf die die Durchkontaktierungen 23 enthaltende Isolierstoffschicht 13 eine weitere Schicht 4 des fotovernetzbaren Isolierstoffes nach der Lehre der Erfindung in der gleichen Weise wie bei Figur 1 beschrieben aufgebracht, in welche Leitungsbahnen 5 und weitere Durchkontaktierungen 6 eingefügt werden. Die Belichtung und Entwicklung der Schicht 4 erfolgt ebenfalls wie bei Figur 1 beschrieben. Außer den Durchbrechungen (6) für die Durchkontaktierung, die mit den Durchkontaktierungen 3 der ersten Isolierstoffschicht 2 (13) zur Auflage kommen, werden in der zweiten Isolierstoffschicht 4 grabenförmige Aussparungen 5 für die gewünschten Leitungsbahnen erzeugt, wobei diese Aussparungen 5 so angeordnet sind, daß mindestens eine Durchkontaktierung 23 der ersten Isolierstoffschicht (2, 13) in eine Aussparung 5 hineinragt. Zum Aufbau der Leitungsbahnen werden die Aussparungen 5 durch Galvanisieren mit einer Metallisierung versehen. Weitere Durchkontaktierungen und Leiterbahnen können dann durch entsprechende Wiederholung der vorstehend beschriebenen Herstellungsstufen aufgebracht werden.

Der neuartige Verdrahtungsaufbau hat gegenüber bekannten Systemen nicht nur den Vorteil einer wesentlich kürzeren Belichtungszeit, sondern erfordert auch keine Zwischen oder Endtemperungen, durch welche Zersetzungsprodukte entstehen können, die die Struktur verändern. Die Verwendung zusätzlicher Schutz- oder Klebefolien, wie in der DE-OS-2 342 407 beschrieben, erübrigt sich ebenfalls. Dadurch vereinfacht sich nicht nur das Verfahren zur Herstellung eines solchen Aufbaues, sondern auch die Zuverlässigkeit in bezug auf die elektrischen Daten.

Aus diesem Grunde und auch wegen der sehr viel kürzeren Belichtungszeit ist das erfindungsgemäße Polymersystem bestens geeignet als hochtemperaturbeständiger Negativlack bei der Herstellung von integrierten Halbleiterschaltungen in VLSI-Technik, bei denen die Erzeugung maßgetreuer Mikrostrukturen bzw. -muster von großer Bedeutung ist. Nähere Einzelheiten sind aus einem Aufsatz von C. D. Eisenbach aus der Zeitschrift "Die Angewandte Makromolekulare Chemie" 109/110 (1982) auf den Seiten 101 bis 112 zu entnehmen.

**Patentansprüche**

1. Durch Bestrahlung zu einem thermostabilen Material vernetzbares Polymersystem, insbesondere geeignet zur Herstellung von Mehrlagenverdrahtungen, auf der Basis eines durch Reaktion von Bisphenolen mit Epichlorhydrin erhältlichen Polykondensats als Grundgerüst, dadurch gekennzeichnet, daß das Polymersystem durch Reaktion des Polykondensats mit lichtempfindlichen Säurechloriden erhalten wird, und wobei das Polykondensat Bisphenolbausteine mit zwei und mehr reaktiven Hydroxylgruppen pro aromatischem Ring besitzt.

2. Polymersystem nach Anspruch 1, dadurch gekennzeichnet, daß am Polykondensat pro regelmäßig wiederkehrender Struktureinheit fünf zur Reaktion mit dem lichtempfindlichen Säurechlorid fähige Hydroxylgruppen vorhanden sind, wobei eine Hydroxylgruppe an den Epichlorhydrinrest und vier Hydroxylgruppen an den Bisphenolrest gebunden sind.

3. Polymersystem nach Anspruch 1 und/oder 2, dadurch gekennzeichnet, daß im Polykondensat die reaktiven Hydroxylgruppen der Bisphenolreste in Form von Hydroxymethylengruppen an den Aromaten gebunden sind.

4. Polymersystem nach mindestens einem der Ansprüche 1 bis 3, dadurch gekennzeichnet, daß zur seiner Herstellung als Polykondensat ein durch Umsetzung von hydroxymethylierten Bisphenolen mit Epichlorhydrin erhältliches Epoxidharz und als lichtempfindliches Säurechlorid Zimtsäure verwendet wird.

5. Polymersystem nach Anspruch 4, dadurch gekennzeichnet, daß anstelle von Zimtsäurechlorid Furanacrylsäurechlorid verwendet wird.

6. Polymersystem nach mindestens einem der Ansprüche 1 und 3 bis 5, dadurch gekennzeichnet, daß das Polykondensat ein Cokondensat ist und sowohl Bisphenolbausteine mit zwei reaktiven Hydroxylgruppen pro aromatischem Ring, als auch Bisphenolbausteine mit weniger als zwei reaktiven Hydroxylgruppen oder gar keine Hydroxylgruppen am Bisphenol enthält.

7. Polymersystem nach mindestens einem der Ansprüche 1 und 3 bis 6, dadurch gekennzeichnet, daß bei Vorliegen eines Cokondensates sowohl Polymerbausteine mit mindestens zwei reaktiven Hydroxylgruppen als auch Polymerbausteine mit weniger als zwei Hydroxylgruppen für die Umsetzung vorhanden sind.

8. Verfahren zur Herstellung von gedruckten Mehrlagenverdrahtungen unter Verwendung des Polymersystems nach mindestens einem der Ansprüche 1 bis 7, dadurch gekennzeichnet, daß

a) eine, vorzugsweise aus Kupfer bestehende Metallfolie (1) mit dem durch Bestrahlung vernetzbaren Polymersystem (2) beschichtet wird,

b) die gewünschte Verdrahtungsstruktur (3) durch Belichtung und Entwicklung in der Polymerschicht (2) erzeugt wird,

c) das freigelegte Metall (1, 3) durch Galvanisieren verstärkt wird, und

d) ohne Tempern und Zwischenschalten von Schutz- oder Klebefolien in der gleichen Weise weitere Lagen (4) durch Beschichtung, Strukturierung und Galvanisierung erzeugt werden.

**Claims**

1. A polymer system which can be cross-linked by irradiation to form a thermostable material, suitable in particular for the production of multi-layer wirings, based on a polycondensate which can be obtained by reaction of bisphenols with epichlorhydrin, as a basic structure, characterized in that the polymer system is obtained by reaction of the polycondensate with light-sensitive acid chlorides, where the polycondensate possesses bisphenol units with two or more reactive hydroxyl groups per aromatic ring.

2. A polymer system as claimed in Claim 1, characterized in that in respect of each regularly recurring structural unit five hydroxyl groups capable of reacting with the light-sensitive acid chloride, are present in the polycondensate, one hydroxyl group being bonded to the epichlorhydrin residue and four hydroxyl groups being bonded to the bisphenol residue.

3. A polymer system as claimed in Claim 1 and/or 2, characterised in that in the polycondensate, the reactive hydroxyl groups of the bisphenol residues are bonded in the form of hydroxymethylene groups to the aromatic rings.

4. A polymer system as claimed in at least one of Claims 1 to 3, characterized in that for its production an epoxide resin, obtained by converting hydroxymethylated bisphenols with epichlorhydrin, is used as polycondensate and cinnamic acid is used as light-sensitive acid chloride.

5. A polymer system as claimed in Claim 4, characterized in that furanacrylic acid chloride is used in place of cinnamic acid chloride.

6. A polymer system as claimed in at least one of Claims 1 and 3 to 5, characterised in that the polycondensate is a co-condensate and contains both bisphenol units with two reactive hydroxyl groups per aromatic ring and also bisphenol units with less than two reactive hydroxyl groups, or no hydroxyl groups, in the bisphenol.

7. A polymer system as claimed in at least one of Claims 1 and 3 to 6, characterized in that when a co-condensate is present, both polymer units containing at least two reactive hydroxyl groups and also polymer units containing less than two hydroxyl groups are available for the conversion reaction.

8. A process for the production of printed multi-layer wirings using the polymer system claimed in at least one of Claims 1 to 7, characterized in that

a) a metal sheet (1), preferably consisting of copper, is coated with the polymer system (2) which can be cross-linked by irradiation,
b) the required wiring structure (3) is formed in the polymer layer (2) by exposure and development,
c) the uncovered metal (1, 3) is reinforced by electroplating,
and
d) further layers (4) are produced in the same way by coating, structuring and electroplating, without annealing and the interposition of protective or adhesive films.

**Revendications**

1. Système polymère, susceptible d'être réticulé par irradiation en un matériau stable à la chaleur et convenant notamment à la fabrication de circuits multicouches, à base d'un produit de polycondensation servant de structure de base et pouvant être obtenu par réaction de bisphénols sur l'épichlorhydrine, caractérisé en ce que le système polymère est obtenu par réaction du produit polycondensé sur des chlorures d'acide sensibles à la lumière, le produit polycondensé ayant des constituants bisphénol ayant deux groupes hydroxyle réactifs ou plus de deux groupes hydroxyle réactifs par cycle aromatique.

2. Système polymère suivant la revendication 1, caractérisé en ce que sur le produit polycondensé il est prévu, par motif récurrent se reproduisant régulièrement, cinq groupes hydroxyle susceptibles de réagir sur le chlorure d'acide sensible à la lumière, un groupe hydroxyle étant lié au radical épichlorhydrine et quatre groupes hydroxyle au radical bisphénol.

3. Système polymère suivant la revendication 1 et/ou 2, caractérisé en ce que dans le produit polycondensé, les groupes hydroxyle réactifs des radicaux bisphénol sont liés aux radicaux aromatiques sous forme de groupes hydroxyméthylène.

4. Système polymère suivant l'une au moins des revendications 1 à 3, caractérisé en ce que pour sa préparation, on utilise comme produit polycondensé une résine époxydique pouvant être obtenue par réaction de bisphénol hydroxyméthylé sur l'épichlorohydrine et comme chlorure d'acide sensible à la lumière de l'acide cinnamique.

5. Système polymère suivant la revendication 4, caractérisé en ce qu'on utilise du chlorure d'acide furanacrylique au lieu du chlorure d'acide cinnamique.

6. Système polymère suivant l'une au moins des revendications 1 et 3 à 5, caractérisé en ce que le produit polycondensé est un produit de co-condensation et contient à la fois des constituants bisphénol ayant deux groupes hydroxyle réactifs par cycle aromatique et des constituants bisphénol ayant moins de deux groupes hydroxyle réactifs ou même pas du tout de groupes hydroxyle sur le bisphénol.

7. Système polymère suivant l'une au moins des revendications 1 et 3 à 6, caractérisé en ce que dans le cas d'un produit de cocondensation, il est prévu à la fois des constituants polymère ayant au moins deux groupes hydroxyle réactifs et des constituants polymère ayant moins de deux groupes hydroxyle pour la réaction.

8. Procédé de fabrication de circuits imprimés multicouches, en utilisant le système polymère suivant l'une au moins des revendications 1 à 7, caractérisé en ce qu'il consiste

a) à revêtir une feuille métallique (1), de préférence en cuivre, d'un système polymère (2) réticulable par exposition à un rayonnement,
b) à produire la structure de circuit (3) souhaitée par exposition et développement dans la couche polymère (2),
c) à renforcer par électrolyse le métal (1, 3) dénudé, et
d) sans recuit ni interposition de feuille de protection ou de feuille adhésive, à produire de la même façon d'autres couches (4) par revêtement, structuration et électrolyse.

FIG 1

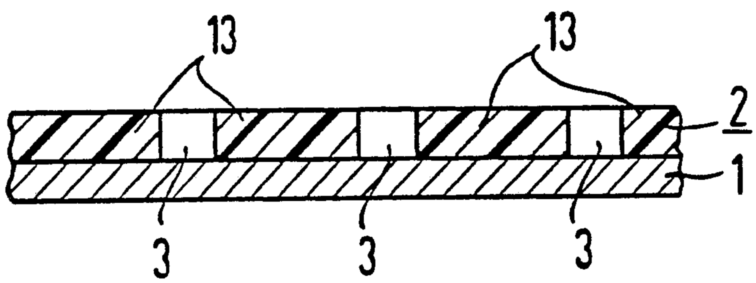


FIG 2